# EUROPÄISCHE PATENTANMELDUNG

(11) **EP 2 293 304 A2**
(43) Veröffentlichungstag der Anmeldung: **09.03.2011**
(21) Anmeldenummer: 10174946.3
(22) Anmeldetag: 01.09.2010
(51) Int. Cl.: G11B 33/02, G11B 33/14

(54) **Gehäuse für einen Datenspeicher sowie eine Speichereinheit, Datenverarbeitungsanlage, Verfahren zur Herstellung des Gehäuses und Verwendung des Gehäuses und der Speichereinheit**

(30) Priorität: 02.09.2009 DE 102009029087
(71) Anmelder: DResearch Digital Media Systems GmbH, 10319 Berlin (DE)
(72) Erfinder: Weber, Dr. Michael, 12683, Berlin (DE)
(74) Vertreter: Gulde Hengelhaupt Ziebig & Schneider

(57) **Zusammenfassung**

Die Erfindung betrifft ein Gehäuse für wenigstens einen Datenspeicher 30 mit einem Gehäusemantel 10 und wenigstens einer im Gehäusemantel 10 angeordneten Aufnahmeeinrichtung zur mechanischen Befestigung des Datenspeichers 30 innerhalb des Gehäusemantels 10 und mit einer Kühleinrichtung 20 zur Kühlung des Datenspeichers.

Es ist vorgesehen, dass an wenigstens einer Seite des Gehäusemantel 10 mit diesem wärmeleitfähig verbunden wenigstens ein Griffelement 20 angeordnet ist, welches zur Verbesserung der haptischen Wirkung sowie zur Realisierung einer großen Oberfläche zwecks Wärmeabfuhr an die Umgebung eine Mehrzahl von oberfiächenvergrößernden Formelementen 21 aufweist.

## Beschreibung

### Beschreibung

Gehäuse für einen Datenspeicher sowie eine Speichereinheit, Datenverarbeitungsanlage, Verfahren zur Herstellung des Gehäuses und Verwendung des Gehäuses und der Speichereinheit

Die vorliegende Erfindung betrifft ein Gehäuse für wenigstens einen Datenspeicher, eine Speichereinheit, welche teilweise aus dem Gehäuse gebildet ist, und eine Datenverarbeitungsanlage, welche die Speichereinheit umfasst. Außerdem betrifft die vorliegende Erfindung ein Verfahren zur Herstellung des Gehäuses sowie die erfindungsgemäße Verwendung des Gehäuses und die Verwendung der Speichereinheit.

Das erfindungsgemäße Gehäuse dient insbesondere als ein sogenannter Wechselrahmen zur Aufnahme eines Datenspeichers wie zum Beispiel einer Festplatte. Das Gehäuse mit darin aufgenommenen Datenspeicher stellt somit eine Speichereinheit dar, die auch als Wechselplattenlaufwerk oder Wechselfestplatte bezeichnet werden kann. Diese haben üblicherweise eine wesentliche höhere Leistungsfähigkeit als herkömmliche Wechselspeicher wie zum Beispiel Disketten, CDs, DVDs oder USB-Sticks. Eine solche Speichereinheit ist üblicherweise transportabel und lässt sich bei entsprechender Ausgestaltung der Anschlüsse in eine Datenverarbeitungsanlage wie zum Beispiel in einen Computer integrieren. Die Speicherkapazität kann bis zu mehrere Gigabytes erreichen. In dem Gehäuse ist der Datenspeicher üblicherweise stoßfest montiert. Das Gehäuse ist in der Geometrie derart ausgestaltet, dass es in einen genormten Schacht in der Datenverarbeitungsanlage eingesteckt werden kann. Es lässt sich somit jede normale Festplatte als Wechselmedium benutzen. Nachteilig an solchen wechselbaren Festplatten ist der relativ große Aufwand zur Kühlung des Datenspeichers, bedingt durch die Wärmeentwicklung beim Betrieb des Datenspeichers sowie ggf. durch den Betrieb der elektronischen Komponenten einer Datenverarbeitungsanlage, an die der Datenspeicher angeschlossen ist. Zur Kühlung werden üblicherweise Lüfter eingesetzt, die einen Luftstrom am Datenspeicher und/oder an dem diesen umgebenden Gehäuse zwecks Wärmeabfuhr erzeugen.

Aus der DE 198 33 050 A1 ist diesbezüglich eine Vorrichtung zur Kühlung von Plattenspeichern bekannt, bei der zur passiven Kühlung des Speichers ein Kühlkörper mit vergrößerter Oberfläche, zum Beispiel mit einer Rippenstruktur, auf einen Teil der Außenwand des Laufwerksgehäuses aufgeklebt wird. Außerdem wird eine aktive Kühlung dadurch bewirkt, dass durch ein Lüfter Kühlungsluft derart angesaugt wird, dass diese an der vergrößerten Oberfläche des Kühlkörpers entlang streicht und somit für eine effiziente Wärmeabfuhr sorgt. Nachteilig an dieser Ausführungsform einer Kühlung eines Datenspeichers ist, dass zur Abfuhr der von der Rippenstruktur freigesetzten Wärme an die Umgebung eine extra Kühleinrichtung benötigt wird, was zu einem höheren materialtechnischen und fertigungstechnischen Aufwand sowie zu einem höheren Energieverbrauch und Volumenbedarf führt.

Die DE 10 2006 036 973 A1 offenbart eine Haltevorrichtung für Vorrichtungen zur Datenspeicherung, bei der ein Behälter zur Aufnahme des Speichermediums außerdem ein Kühlelement aufweist, welches in direktem Kontakt mit dem Speichermedium steht. In weiterer Ausbildung ist vorgesehen, dass der Behälter zur Aufnahme des Speichermediums mit einer außerhalb des Gehäuses angeordneten Kühlvorrichtung zur verbesserten Kühlung des Mediums verbunden ist. Bei dieser Ausführungsform einer Einrichtung zur Kühlung eines Datenspeichermediums wird ein relativ großes Bauvolumen um das Datenspeichermedium herum benötigt. Um das Datenspeichermedium effizient kühlen zu können, muss außerdem zusätzlich eine externe Kühlvorrichtung verwendet werden. Neben dem erhöhten Bauvolumen ist diese Kühleinrichtung demzufolge ebenfalls mit einem erhöhten Energiebedarf zur Realisierung der Kühlung sowie mit einem erhöhten material- und fertigungstechnischen Aufwand verbunden.

Der vorliegenden Erfindung liegt somit die Aufgabe zugrunde, ein Gehäuse sowie eine das Gehäuse umfassende Speichereinheit und wiederum eine die Speichereinheit umfassende Datenverarbeitungsanlage und ein Verfahren zur Herstellung des Gehäuses sowie zur Herstellung der Speichereinheit zur Verfügung zu stellen, mittels derer in einfacher und kostengünstiger Weise ein Gehäuse bzw. eine Speichereinheit zur Verfügung gestellt wird, mittels dessen effizient und zuverlässig die Kühlung eines Datenspeichermediums realisierbar ist.

Diese Aufgabe wird erfindungsgemäß durch das im Anspruch 1 genannte Gehäuse, durch die im Anspruch 10 genannte Speichereinheit, die im Anspruch 11 genannte Datenverarbeitungsanlage sowie durch das im Anspruch 12 genannte Verfahren zur Herstellung des Gehäuses erfindungsgemäß gelöst. Vorteilhafte Ausgestaltungen des erfindungsgemäßen Gehäuses sind in den Unteransprüchen 2 bis 9 angegeben. Eine vorteilhafte Ausgestaltung des Verfahrens zur Herstellung des Gehäuses ist im Anspruch 13 angegeben. Die Erfindung ergänzend wird außerdem die Verwendung des erfindungsgemäßen Gehäuses sowie der erfindungsgemäßen Speichereinheit zur Verfügung gestellt.

Erfindungsgemäß wird ein Gehäuse für wenigstens einen Datenspeicher mit einem Gehäusemantel und wenigstens einer im Gehäusemantel angeordneten Aufnahmeeinrichtung zur mechanischen Befestigung des Datenspeichers innerhalb des Gehäusemantels und mit einer Kühleinrichtung zur Kühlung des Datenspeichers zur Verfügung gestellt. An wenigstens einer Seite des Gehäusemantels ist mit diesem wärmeleitfähig verbunden wenigstens ein Griffelement angeordnet, welches zur Verbesserung der haptischen Wirkung sowie zur Realisierung einer großen Oberfläche zwecks Wärmeabfuhr an die Umgebung eine Mehrzahl von oberflächenvergrößernden Formelementen aufweist. Dieses Gehäuse dient zur Aufnahme eines Datenspeichers und zur Verbindung des Datenspeichers mit einer Datenverarbeitungsanlage. Das Griffelement zum Hineinschieben bzw. Herausziehen des Gehäuses in bzw. aus der Datenverarbeitungsanlage ist dabei als Kühlkörper ausgestaltet. Vorzugsweise ist das Griffelement dabei an einer offenen Seite des Gehäusemantels, der im Wesentlichen den Querschnitt eines Hohlprofils aufweist, angeordnet. Bevorzugt sind außerdem am Gehäusemantel erste Formelemente angebracht, die in Ihrer Form zumindest teilweise komplementär zu zweiten, an der Datenverarbeitungsanlage angeordneten Formelementen ausgestaltet sind, um ein einfaches und sicheres Einschieben des Gehäuses in die Datenverarbeitungsanlage zu ermöglichen. Als Datenspeicher können zum Beispiel Festplatten verwendet werden, die im Gehäuse zu montieren sind und mit diesem zusammen in einer Datenverarbeitungsanlage integriert werden können. Die Befestigung des Gehäuses in der Datenverarbeitungsanlage ist dabei vorzugsweise reversibel. Das erfindungsgemäße Gehäuse ist jedoch nicht auf die Aufnahmebefestigung von Festplatten eingeschränkt, sondern es kann auch vorgesehen sein, dass im Gehäuse Wechseldatenspeicher, die auch Wechselspeicher genannt werden, aufgenommen werden können. Es sind außerdem in bevorzugter Ausgestaltung am Gehäuse Datenübertragungsleitungen vorgesehen, die an den Datenspeicher angeschlossen bzw. anzuschließen sind, welche entweder in einer separaten Schnittstelle enden oder in einer im Gehäuse integrierten Schnittstelle, die dazu dient, bei in einer Datenverarbeitungsanlage aufgenommen Gehäuse und darin integrierten Datenspeicher den Datenaustausch zwischen den Datenspeicher und der Datenverarbeitungsanlage zu realisieren.

Es ist dabei insbesondere vorgesehen, dass die oberflächenvergrößernden Formelemente Kühlrippen sind. Diese Kühlrippen erstrecken sich über die gesamte Länge des Griffelementes. Das Verhältnis der jeweiligen Kühlrippenbreite B zur Kühlrippenhöhe H sollte 1/5 bis 3/5 betragen. Bevorzugt ist ein Verhältnis von 1,5/5 zu verwenden. Der Abstand zwischen den Rippen sollte dabei genauso breit sein wie die Breite der jeweiligen zu einander beabstandeten Kühlrippen.

Zur Verbesserung der Möglichkeit der Einleitung einer manuellen Zugkraft in das Griffelement ist vorgesehen, dass die Kühlrippen quer zur vorgesehen Einschubrichtung verlaufen. Die Einschubrichtung ist dabei die, die durch den Schacht in der Datenverarbeitungsanlage zum Einschieben des Gehäuses vorgegeben ist.

Vorteilhafterweise ist das Material des Gehäusemantels ein Metall, wobei sich insbesondere Aluminium anbietet und eine Aluminium-Stranggussprofil die besten Vorteile hinsichtlich Stabilität, Wärmeabfuhr sowie Fertigungsaufwand bietet.

Die wärmeleitfähige Verbindung zwischen dem Gehäusemantel und dem Griffelement sollte mittels einer Wärmebrücke realisiert sein. Diese Wärmebrücke dient dem Wärmetransport vom Gehäusemantel zum Griffelement. Dabei kann die Wärmebrücke durch eine unmittelbare mechanische Verbindung mittels flächiger Anlage des Griffelementes am Gehäusemantel und Befestigung mittels wenigstens einer Schraub- oder Nietverbindung hergestellt sein.

Eine alternative Ausführungsform ist eine Wärmebrücke mittelbar zwischen dem Gehäusemantel und dem Griffelement durch wenigstes ein Koppelelement in Form wenigstens einen Drahtes oder Bügels zum Transport der Wärme vom Gehäusemantel zum Griffelement.

In bevorzugter Ausführungsform ist wenigstens eines der beiden Bauteile Gehäusemantel oder Griffelement aus einem Aluminium-Stranggussprofil gefertigt.

Um einen Wärmeaustausch zwischen dem Datenspeicher und elektronischen Systemen einer Datenverarbeitungsanlage, in die das Gehäuse eingeschoben ist, zu vermeiden, ist vorgesehen, dass der Gehäusemantel bis auf den Bereich der wärmeleitfähigen Kontaktierung mit dem Griffelement eine thermische Isolierung aufweist. Die thermische Isolierung verhindert bzw. verringert die Wärmeabfuhr über das Gehäuse. Um einen Wärmestau zu vermeiden, muss demzufolge die Wärmeabfuhr über das Griffelement um so effizienter wirken.

Erfindungsgemäß und zur Lösung der Aufgabe wird außerdem eine Speichereinheit zur Verfügung gestellt, welche im Wesentlichen das erfindungsgemäße Gehäuse und wenigstens einen darin aufgenommenen Datenspeicher, insbesondere eine Festplatte, umfasst. Die Festplatte ist dabei entweder unlösbar im Gehäuse montiert oder reversibel im Gehäuse befestigt.

Zur Lösung der Aufgabe wird zudem eine Datenverarbeitungsanlage zur Verfügung gestellt, welche wenigstens eine erfindungsgemäße Speichereinheit umfasst. In diese Datenverarbeitungsanlage ist die Speichereinheit, umfassend das Gehäuse und den Datenspeicher, zur Realisierung eines Datenaustausches zwischen der Speichereinheit und der Datenverarbeitungsanlage eingeschoben. Die Speichereinheit ist dabei reversibel in der Datenverarbeitungsanlage befestigt.

Zur Lösung der Aufgabe wird außerdem ein Verfahren zur Herstellung des erfindungsgemäßen Gehäuses angegeben, bei dem ein Gehäusemantel und wenigstens ein Griffelement mit einer Mehrzahl von oberflächenvergrößernden Formelementen zur Verfügung gestellt wird, das Griffelement mit wenigstens zwei Durchgangsbohrungen versehen wird und durch die Durchgangsbohrungen mittels Bolzen mit dem Gehäusemantel verschraubt wird. Dabei ist der Gehäusemantel bevorzugt ein Stranggussprofil. Die Durchgangsbohrungen können mit Senkungen zur Aufnahme von Bolzenköpfen versehen sein. Die Bolzen können dabei selbstschneidend ausgeführt sein und sich in Materialkonzentrationsbereiche am Gehäusemantel eindrehen, oder sie wirken alternativ mit Innengewinden am Gehäusemantel zusammen.

In bevorzugter Ausgestaltung des Verfahrens ist vorgesehen, dass vor der Verschraubung des Griffelementes an dem Gehäusemantel aus dem Griffelement ein Absatz mit der äußeren Kontur der Gehäusemantelseite, an der das Griffelement zu befestigen ist, herausgefräst wird. Es lässt sich damit ein formschlüssiges Einsetzen eines Gehäusemantelabschnittes in das Griffelement und somit eine Vergrößerung der Kontaktierungsoberfläche und damit eine bessere Wärmeübertragung zwischen dem Gehäusemantel und dem Griffelement erreichen.

Die Erfindung ergänzend wird außerdem die Verwendung des erfindungsgemäßen Gehäuses zur Aufnahme und Befestigung wenigstens eines Datenspeichers und dessen Kühlung angegeben.

Außerdem wird die Verwendung der erfindungsgemäßen Speichereinheit zur Speicherung von wenigstens von einer Aufzeichnungseinrichtung aufgenommenen Daten, insbesondere von in einem Fahrzeug angeordneten Videoaufzeichnungssystemen, angegeben. Dabei soll die Speichereinheit insbesondere geeignet sein, in Fahrzeugen des öffentlichen Nah- oder Fernverkehrs aufgezeichnete Daten zu speichern und bei Bedarf durch Herausziehen der Speichereinheit aus einer Datenverarbeitungsanlage des Fahrzeuges zur Verfügung zu stellen. Die Speichereinheit kann anschließend mit einer anderen, außerhalb des Fahrzeuges angeordneten Datenverarbeitungsanlage wiederum durch Einschieben verbunden werden, so dass extern die im Fahrzeug aufgenommenen Daten in einfacher und zuverlässiger Weise ausgewertet werden können.

Die Erfindung soll anhand der beiliegenden Zeichnungen erläutert werden. Es zeigen dabei:
- Figur 1: ein erfindungsgemäßes Gehäuse in perspektivischer Ansicht,
- Figur 2: das Gehäuse mit darin angeordneten Datenspeicher,
- Figur 3: eine perspektivische Ansicht des Griffelementes von vorn und
- Figur 4: eine perspektivische Ansicht des Griffelementes von hinten.

Das erfindungsgemäße Gehäuse umfasst einen Gehäusemantel 10, an dessen Stirnseite ein Griffelement bzw. eine Kühleinrichtung 20 angeordnet ist. An der dem Griffelement 20 gegenüberliegenden Seite des Gehäusemantels 10 ist eine nicht dargestellte Schnittstelle 13 zur Verbindung mit einer Datenverarbeitungsanlage angeordnet.

Das als Kühleinrichtung funktionierende Griffelement 20 weist eine Mehrzahl von oberflächenvergrößernden Formelementen in Form von Kühlrippen 21 auf. Diese Kühlrippen 21 verlaufen über die gesamte Länge des Griffelementes 20. Senkrecht zur Erstreckungsrichtung der Kühlrippen 21 sind Durchgangsbohrungen 22 im Griffelement 20 angeordnet.

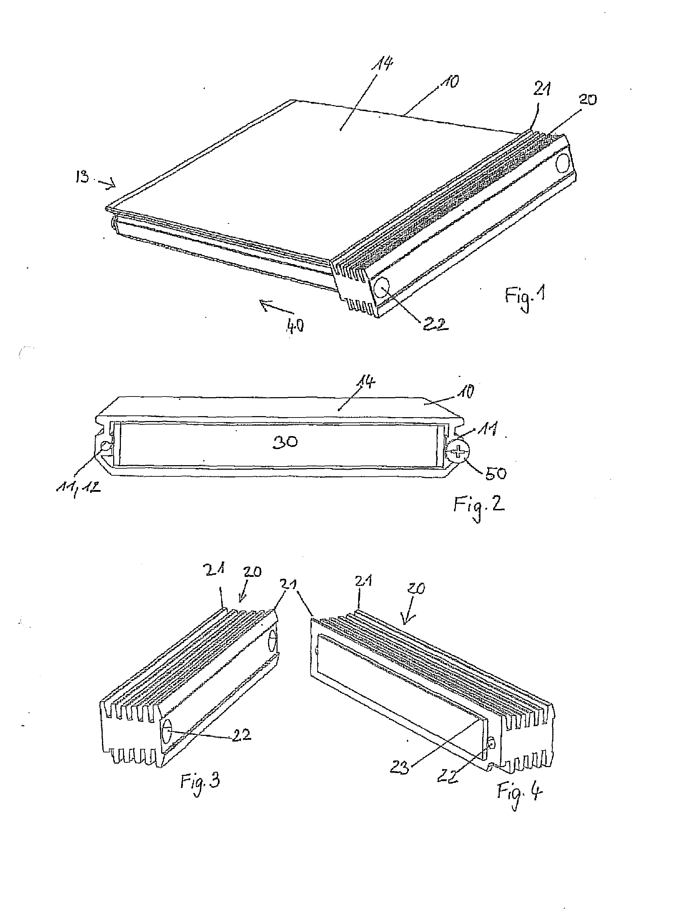

Wie aus Figur 2 ersichtlich ist, lassen sich Schraub- oder Nietverbindungen 50 durch die Durchgangsbohrungen 22 mit Schraubkanälen 12, welche im Materialkonzentrationsbereichen 11 an der Innenseite des Gehäusemantels 10 angeordnet sind, verbinden. Dabei können Schrauben verwendet werden, die selbstschneidend ein Gewinde beim Einschrauben herstellen.

Wie in Figur 2 ersichtlich ist, befindet sich im Inneren des als Hohlprofil ausgestalteten Gehäusemantels 10 der Datenspeicher 30. Bei dessen Betrieb entsteht Wärme, die dieser über Wärmestrahlung und Wärmeleitung an den Gehäusemantel 10 abgibt. Durch die Anlage des Griffelementes 20 am Gehäusemantel 10 wird die Wärme in das Griffelement 20 übertragen und aufgrund der großen Oberfläche, hergestellt durch die Kühlrippen 21, an die Umgebungsluft übertragen. Durch die Position des Griffelementes 20 an der Stirnseite des Gehäusemantels 10 ragt dieses aus einer Datenverarbeitungsanlage heraus, wenn das Gehäuse zum Betrieb des Datenspeichers 30 in eine Datenverarbeitungsanlage eingeschoben ist. Das heißt, dass Wärme von den Kühlrippen 21 relativ ungehindert an die Umgebungsluft abgegeben werden kann.

Zur Vergrößerung der Fläche der mechanischen Kontaktierung zwischen dem Griffelement 20 und dem Gehäusemantel 10 ist am Griffelement 20 ein Absatz 23 herausgefräst, der es ermöglicht, das Griffelement 20 zumindest abschnittsweise auf den Gehäusemantel 10 aufzuschieben und somit einen geringeren Widerstand für den Wärmetransport zu realisieren.

Das derart hergestellte erfindungsgemäße Gehäuse bzw. die damit hergestellte Speichereinheit lässt sich in Einschubrichtung 40 in einen entsprechend komplementär ausgeformten Schacht in einer Datenverarbeitungsanlage einschieben, wodurch die Schnittstelle 13 am Gehäusemantel 10 mit zum Beispiel einem passenden Stecker oder einer Buchse in der Datenverarbeitungsanlage, verbunden wird. Zur Vermeidung von Wärmeübertragung vom Datenspeicher 30 an die ihn umgebenen Datenverarbeitungsanlage bzw. eines Wärmeüberganges von der Datenverarbeitungsanlage zum Wärmespeicher 30 kann der Gehäusemantel 10 mit einer thermischen Isolierung 14 an seiner Oberfläche versehen sein, die bis auf den Bereich der Kontaktierung mit dem Griffelement 20 im Wesentlichen den Gehäusemantel 10 vollständig abdeckt. Dadurch, dass das Griffelement 20 aus der Datenverarbeitungsanlage herausragt, ist eine ausreichende Wärmeabfuhr aufgrund dessen großer Oberfläche selbst bei thermischer Isolierung des Gehäusemantels 10 gegeben.

Neben der Funktion der optimalen Wärmeabfuhr hat das Griffelement 20 den Vorteil, dass es aufgrund der angeordneten Kühlrippen 21 für einen Benutzer eine bessere Haptik bzw. größere Oberflächenrauigkeit bietet, die ihm ein Herausziehen des Gehäuses bzw. der Speichereinheit aus einer Datenspeicheranlage erleichtert.

### Bezugszeichenliste

- 10: Gehäusemantel
- 11: Materialkonzentrationsbereich
- 12: Schraubkanal
- 13: Schnittstelle
- 14: thermische Isolierung
- 20: Kühleinrichtung, Griffelement
- 21: oberflächenvergrößerndes Formelement, Kühlrippe
- 22: Durchgangsbohrung
- 23: Absatz
- 30: Datenspeicher
- 40: Einschubrichtung
- 50: Schraub- oder Nietverbindung

## Patentansprüche

1. Gehäuse für wenigstens einen Datenspeicher mit einem Gehäusemantel (10) und wenigstens einer im Gehäusemantel (10) angeordneten Aufnahmeeinrichtung zur mechanischen Befestigung des Datenspeichers innerhalb des Gehäusemantels (10) und mit einer Kühleinrichtung (20) zur Kühlung des Datenspeichers, **dadurch gekennzeichnet, dass** an wenigstens einer Seite des Gehäusemantels (10) mit diesem wärmeleitfähig verbunden wenigstens ein Griffelement (20) angeordnet ist, welches zur Verbesserung der haptischen Wirkung sowie zur Realisierung einer großen Oberfläche zwecks Wärmeabfuhr an die Umgebung eine Mehrzahl von oberflächenvergrößernden Formelementen (21) aufweist.

2. Gehäuse nach Anspruch 1, **dadurch gekennzeichnet, dass** die oberflächenvergrößernden Formelemente Kühlrippen (21) sind.

3. Gehäuse nach Anspruch 2, **dadurch gekennzeichnet, dass** die Kühlrippen (21) quer zur vorgesehenen Einschubrichtung (40) verlaufen.

4. Gehäuse nach wenigstens einem der vorhergehenden Ansprüche, **dadurch gekennzeichnet, dass** das Material des Gehäusemantels (10) ein Metall ist.

5. Gehäuse nach wenigstens einem der vorhergehenden Ansprüche, **dadurch gekennzeichnet, dass** die wärmeleitfähige Verbindung zwischen dem Gehäusemantel (10) und dem Griffelement (20) mittels einer Wärmebrücke realisiert ist.

6. Gehäuse nach Anspruch 5, **dadurch gekennzeichnet, dass** die Wärmebrücke durch eine unmittelbare mechanische Verbindung mittels flächiger Anlage des Griffelementes (20) am Gehäusemantel (10) und Befestigung mittels wenigstens einer Schraub- oder Nietverbindung (50) hergestellt ist.

7. Gehäuse nach Anspruch 5, **dadurch gekennzeichnet, dass** die Wärmebrücke mittelbar zwischen Gehäusemantel (10) und Griffelement (20) durch wenigstens ein Koppelelement in Form wenigstens eines Drahtes oder Bügels zum Transport der Wärme vom Gehäusemantel (10) zum Griffelement (20) hergestellt ist.

8. Gehäuse nach wenigstens einem der vorhergehenden Ansprüche, **dadurch gekennzeichnet, dass** der Gehäusemantel (10) und/oder das Griffelement (20) aus einem Aluminium-Stranggussprofil gefertigt ist.

9. Gehäuse nach wenigstens einem der vorhergehenden Ansprüche, **dadurch gekennzeichnet, dass** der Gehäusemantel (10) bis auf den Bereich der wärmeleitfähigen Kontaktierung mit dem Griffelement (20) eine thermische Isolierung (14) aufweist.

10. Speichereinheit mit einem Gehäuse nach wenigstens einem der Ansprüche 1-9 und wenigstens einem darin aufgenommenen Datenspeicher (30), insbesondere einer Festplatten.

11. Datenverarbeitungsanlage, welche wenigstens eine Speichereinheit gemäß Anspruch 10 umfasst.

12. Verfahren zur Herstellung des Gehäuses nach wenigstens einem der Ansprüche 1-9, bei dem ein Gehäusemantel und wenigstens ein Griffelement mit einer Mehrzahl von oberflächenvergrößernden Formelementen zur Verfügung gestellt wird, **dadurch gekennzeichnet, dass** das Griffelement (20) mit wenigstens zwei Durchgangsbohrungen (22) versehen wird und das Griffelement (20) durch die Durchgangsbohrungen (22) mittels Bolzen mit dem Gehäusemantel (10) verschraubt wird.

13. Verfahren zur Herstellung des Gehäuses nach Anspruch 12, **dadurch gekennzeichnet, dass** vor der Verschraubung des Griffelementes (20) an den Gehäusemantel (10) aus dem Griffelement (20) ein Absatz mit der äußeren Kontur der Gehäusemantelseite, an der das Griffelement (20) zu befestigen ist, herausgefräst wird.

14. Verwendung des Gehäuses nach wenigstens einem der Ansprüche 1 - 9 zur Aufnahme und Befestigung wenigstens eines Datenspeichers (30) und dessen Kühlung.

15. Verwendung der Speichereinheit nach Anspruch 10 zur Speicherung von wenigstens von einer Aufzeichnungseinrichtung aufgenommenen Daten, insbesondere von in einem Fahrzeug angeordneten Video-Aufzeichnungssystem.
